# EUROPEAN PATENT APPLICATION

(11) **EP 1 879 224 A2**
(43) Date of publication of application: **16.01.2008**
(21) Application number: 07117838.8
(22) Date of filing: 21.10.2002
(51) Int. Cl.: H01L 21/322

(54) **Process for controlling denuded zone depth in an ideal oxygen precipitating silicon wafer**

(30) Priority: 10.04.2002 US 371324 P
(62) Divisional of application: 02773835.0
(71) Applicant: MEMC Electronic Materials, Inc., St. Peters, Missouri 63376 (US)
(72) Inventor: Libbert, Jeffrey L., St Peters, MO 63376 (US); Binns, Martin Jeffrey, St Peters, MO 63376 (US); Falster, Robert J., St Peters, MO 63376 (US)
(74) Representative: Smaggasgale, Gillian Helen

(57) **Abstract**

The present invention is directed to a single crystal Czochralski-type silicon wafer, and a process for the preparation thereof, which has non-uniform distribution of crystal lattice vacancies therein, the peak concentration being present in the wafer bulk between an imaginary central plane and a surface of the wafer, such that, upon being subjected to the heat treatment cycles of essentially any arbitrary electronic device manufacturing process, the wafer forms oxygen precipitates in the wafer bulk and a thin or shallow precipitate-free zone near the wafer surface.

## Description

### BACKGROUND OF THE INVENTION

The present invention generally relates to the preparation of a semiconductor material substrate, especially a silicon wafer, which is suitable for used in the manufacture of electronic components. More particularly, the present invention relates to a process for the treatment of silicon wafers to form a non-uniform distribution of crystal lattice vacancies therein such that, upon being subjected to the heat treatment cycles of essentially any arbitrary electronic device manufacturing process, the wafers form oxygen precipitates in the bulk and a thin or shallow precipitate-free zone near the surface.

Single crystal silicon, which is the starting material for most processes for the fabrication of semiconductor electronic components, is commonly prepared with the so-called Czochralski (CZ) process wherein a single seed crystal is immersed into molten silicon and then grown by slow extraction. Molten silicon is contaminated with various impurities, among which is mainly oxygen, during the time it is contained in a quartz crucible. At the temperature of the silicon molten mass, oxygen comes into the crystal lattice until it reaches a concentration determined by the solubility of oxygen in silicon at the temperature of the molten mass and by the actual segregation coefficient of oxygen in the solidified silicon. Such concentrations are greater than the solubility of oxygen in solid silicon at temperatures typical for the processes used to fabricate electronic devices. As the crystal grows from the molten mass and cools, therefore, the solubility of oxygen in it decreases rapidly, whereby in the remaining slices or wafers, oxygen is present in supersaturated concentrations.

Thermal treatment cycles which are typically employed in the electronic device manufacturing processes can cause the precipitation of oxygen in silicon wafers which are supersaturated in oxygen. Depending upon their location in the wafer and their relative size, the precipitates can be harmful or beneficial. Small oxygen clusters are electrically active thermal donors and can reduce resistivity regardless of location in the wafer. Large oxygen precipitates located in the active device region of the wafer can impair the operation of the device but when located in the bulk of the wafer, however, are capable of trapping undesired metal impurities that may come into contact with the wafer during, for example, device fabrication processes. This is commonly referred to as internal or intrinsic gettering ("IG").

Falster et al. developed a rapid thermal process to reliably and reproducibly form a distribution of crystal lattice vacancies which, in turn, establish a template for oxygen precipitation in silicon wafers. (See, e.g., U.S. Patent Nos.: 5,994,761; 6,191,010; and, 6,180,220; all of which are incorporated herein by reference in their entirety.) The "ideal precipitating process" described therein generally yields a non-uniform distribution of crystal lattice vacancies, with the concentration in the wafer bulk being higher than in a surface layer. Upon a subsequent, oxygen precipitation heat treatment, the high concentration of vacancies in the wafer bulk form oxygen precipitate nucleation centers which aid in the formation and growth of oxygen precipitates, the concentration of vacancies in the near-surface region being insufficient to do so. As a result, a denuded zone forms in the near-surface region and oxygen precipitates, sometimes referred to as bulk microdefects or simply BMDs, form in the wafer bulk. As described therein, denuded zones depth may be controlled by controlling the cooling rate of the wafer from the anneal temperature to the temperature at which crystal lattice vacancies become essentially immobile for any commercially practical time period (e.g., 700°C).

However, for some applications, such high resistivity wafers, denuded zones of such depth may not always be desirable or advantageous. This is because, in general, oxygen removal efficiency decreases with increasing denuded zone depth because the distance over which the interstitial oxygen must travel in order to be removed from solution (either by precipitating at a BMD or by diffusing to the wafer surface) increases. As a result, once a denuded zone becomes too deep or thick, there is the potential that the elevated interstitial oxygen concentration in the center of this zone (interstitial oxygen near the surface and bulk of the wafer having sufficient time to diffuse to sites where they are consumed) will be sufficiently high, such that thermal donor formation will occur during a device manufacturing process, thus decreasing resistivity in the device layer of the wafer. This may be particularly problematic in wafers having deep denuded zones and oxygen concentrations in excess of about 10 PPMA.

### SUMMARY OF THE INVENTION

Among the features of the present invention, therefore, is the provision of a single crystal silicon wafer, and a process for the preparation thereof, which has a non-uniform distribution of crystal lattice vacancies such that, during the heat treatment cycles of essentially any electronic device manufacturing process, an ideal, non-uniform depth distribution of oxygen precipitates will form; the provision of such a wafer which will optimally and reproducibly form a denuded zone of a sufficient shallow depth and a sufficient density of oxygen precipitates in the wafer bulk; the provision of such a wafer in which the formation of the denuded zone and the formation of the oxygen precipitates in the wafer bulk is not dependant upon differences in oxygen concentration in these regions of the wafer; the provision of such a process in which the formation of the denuded zone does not depend upon the out-diffusion of oxygen; the provision of such a wafer in which the thickness of the resulting denuded zone is essentially independent of the details of the IC manufacturing process sequence; and, the provision of such a wafer in which the formation of the denuded zone and the formation of the oxygen precipitates in the wafer bulk are not influenced by the thermal history and the oxygen concentration of the Czochralski-grown, single crystal silicon ingot from which the silicon wafer is obtained.

Briefly, therefore, the present invention is directed to a wafer sliced from a single crystal silicon ingot grown in accordance with the Czochralski method. The wafer comprises (A) a front surface, a back surface, an imaginary central plane approximately equidistant between the front and back surfaces, a front surface layer which comprises a region of the wafer between the front surface and a distance, D₁, measured from the front surface and toward the central plane, and a bulk layer which comprises the imaginary central plane but not the front surface layer, and (B) a non-uniform concentration of crystal lattice vacancies in which a peak concentration is in the bulk layer between the central plane and the front surface layer, the concentration generally decreasing in the direction of both the front surface layer and the central plane, wherein (i) D₁ is at least about 5 microns but less than about 30 microns, and (ii) upon being subjected to an oxygen precipitation heat-treatment at a temperature in excess of about 700°C, the surface layer has less than about 1 x 10⁷ cm⁻³ oxygen precipitates while the bulk layer has more than about 1 x 10⁷ cm⁻³ oxygen precipitates.

The present invention is further directed to an epitaxial wafer or a silicon on insulator structure, and the processes for the preparation thereof, comprising such a wafer.

The present invention is further directed to such a wafer wherein the resistivity thereof is less than about 50 ohm cm.

The present invention is further directed to a process for preparing a silicon wafer. The wafer is sliced from a single crystal silicon ingot, grown in accordance with the Czochralski method, and has a front surface, a back surface, an imaginary central plane approximately equidistant between the front and back surfaces, a front surface layer which comprises a region of the wafer between the front surface and a distance, D₁, which as measured from the front surface and toward the central plane is greater than about 5 microns but less than about 30 microns, and a bulk layer which comprises the imaginary central plane but not the front surface layer. The process comprises (A) heat-treating the single crystal silicon wafer in an atmosphere comprising a nitrogen-containing gas and an oxygen-containing gas, the concentration of oxygen in the atmosphere being less than about 500 PPMA, to form crystal lattice vacancies in the front surface layer and in the bulk layer; (B) cooling the heat-treated wafer to produce therein a non-uniform concentration of crystal lattice vacancies in which a peak concentration is in the bulk layer between the central plane and the front surface layer, the concentration generally decreasing in the direction of both the front surface layer and the central plane, and (C) subjecting the cooled wafer to an oxygen precipitation heat-treatment at a temperature in excess of about 700°C to form a wafer having a denuded zone in the front surface layer and oxygen precipitates in the bulk layer.

Other objects and features of this invention will be in part apparent and in part pointed out hereinafter.

### BRIEF DESCRIPTION OF THE DRAWINGS

FIG. 1 is a schematic depiction of the present process, wherein a silicon wafer is thermally annealed (S1) and rapidly cooled (S2), in order to obtained a non-uniform distribution of crystal lattice vacancies, and then subjected to an oxygen precipitation heat-treatment (S3) to obtain a wafer having a denuded zone of a desired depth.
FIG. 2 is a graphical depiction of a wafer bulk precipitate density versus secondary anneal temperature for three different oxygen ranges as a function of anneal time.

### DETAILED DESCRIPTION OF THE PREFERRED EMBODIMENTS

In accordance with the present invention, a single crystal silicon wafer having essentially any oxygen content attainable by the Czochralski growth process may be subjected to a thermal treatment and rapid cooling in a controlled, oxygen-containing atmosphere to obtain a wafer having a non-uniform distribution of crystal lattice vacancies which establish a template for oxygen precipitation in a subsequent oxygen precipitation heat-treatment. In one embodiment, the template enables the formation of a relatively thin denuded zone (e.g., less than about 30 microns) in a near surface region of the wafer and oxygen precipitates in the wafer bulk. The present process is particularly advantageous because it enables the efficient and reliable production of silicon wafers which, upon being subjected to essentially any electronic device manufacturing process, will have such thin denuded zones.

### A. Starting Material

In one embodiment, the starting material for the wafer of the present invention is a silicon wafer which has been sliced from a single crystal ingot grown in accordance with conventional Czochralski ("CZ") crystal growing methods, typically having a diameter of about 150 mm, 200 mm, 300 mm or more. The wafer may be polished or, alternatively, lapped and etched but not polished. Such methods, as well as standard silicon slicing, lapping, etching, and polishing techniques are disclosed, for example, in F. Shimura, Semiconductor Silicon Crystal Technology, Academic Press, 1989, and Silicon Chemical Etching, (J. Grabmaier ed.) Springer-Verlag, New York, 1982 (incorporated herein by reference). Preferably, the wafers are polished and cleaned by standard methods known to those skilled in the art. See, for example, W.C. O'Mara et al., Handbook of Semiconductor Silicon Technology, Noyes Publications.

In general, the starting wafer may have an oxygen concentration failing anywhere within the range attainable by the CZ process, which is typically about 5 x 10¹⁷ to about 9 x 10¹⁷ atoms/cm³ or about 10 to about 18 PPMA (e.g., about 10 to about 12 or 15 PPMA, as determined in accordance with ASTM calibration; Oᵢ = 4.9 α, where α is the absorption coefficient of the 1107 cm⁻¹ absorption band; new ASTM standard F-121-83). In addition, the starting wafer preferably has an absence of stabilized oxygen precipitates (i.e., oxygen precipitates which cannot be dissolved or annealed out of the wafer at a temperature of about 1200°C or less) in the near-surface region of the wafer.

Substitutional carbon, when present as an impurity in single crystal silicon, has the ability to catalyze the formation of oxygen precipitate nucleation centers. For this and other reasons, therefore, it is preferred that the single crystal silicon starting material have a low concentration of carbon. That is, the single crystal silicon preferably has a concentration of carbon which is less than about 5 x 10¹⁶ atoms/cm³, preferably which is less than 1 x 10¹⁶ atoms/cm³, and more preferably less than 5 x 10¹⁵ atoms/cm³.

### B. Creating a Template for Oxygen Precipitation

In general, a rapid thermal treatment is carried out to form a distribution of crystal lattice vacancies which establish a template for oxygen precipitation in the wafer. In one embodiment, the template is for a wafer having oxygen precipitates in the wafer bulk but a low density of, and preferably an essential absence of, oxygen precipitates in a near-surface region; advantageously, denuded zones of any desired depth may be obtained. For example, denuded zone depths of 70 micrometers, 50 micrometers, 30 micrometers, 20 micrometers, or even 10 micrometers or less may be reliably and reproducibly obtained.

The use of a rapid thermal process to form a distribution of crystal lattice vacancies which, in turn, establish a template for oxygen precipitation, is generally described in Falster et al., U.S. Patent Nos. 5,994,761, 6,191,010 and 6,180,220, all of which are incorporated herein by reference in their entirety. The "ideal precipitating process" described therein typically yields a non-uniform distribution of crystal lattice vacancies, with the concentration in the wafer bulk being higher than in a surface layer. Upon a subsequent, oxygen precipitation heat treatment, the high concentration of vacancies in the wafer bulk form oxygen precipitate nucleation centers which aid in the formation and growth of oxygen precipitates, the concentration of vacancies in the near-surface region being insufficient to do so. As a result, a denuded zone forms in the near-surface region and oxygen precipitates, sometimes referred to as bulk microdefects or simply BMDs, form in the wafer bulk. As described therein, denuded zones of a depth in the range of 50 to 70 microns may reliably be formed.

However, denuded zones of such depth may not always be advantageous. For example, in general, oxygen removal efficiency decreases with increasing denuded zone depth, because the distance over which the interstitial oxygen must travel in order to be removed from solution (either by precipitating at a BMD or by diffusing to the wafer surface) increases. As a result, once a denuded zone becomes too deep or thick (e.g., greater than about 30 microns), there is the potential that the elevated interstitial oxygen concentration in the center of this zone (interstitial oxygen near the surface and bulk of the wafer having sufficient time to diffuse to sites where they are consumed) will be sufficiently high, such that thermal donor formation will occur during a device manufacturing process.

Thermal donor formation is not favorable in, for example, high resistivity applications (i.e., applications requiring resistivities in excess of about 50 ohm cm), because the thermal donors act to decrease resistivity in the device layer of the wafer. This may be particularly problematic in "ideal precipitating wafers" with oxygen concentrations in excess of about 10 PPMA. One aspect of the present invention, therefore, is controlling the depth of the denuded zone, which in turn, affects the oxygen removal efficiency in a subsequent oxygen precipitation heat treatment.

The concentration (number density) of oxygen precipitation sites also influences the efficiency of oxygen removal during an oxygen precipitation heat-treatment, the oxygen removal efficiency increasing as a function of an increasing concentration of sites. Advantageously, the concentration of sites increases as a function of increasing rapid thermal annealing temperature; for all practical purposes, the concentration of sites is essentially independent of oxygen concentration (over the range of oxygen concentrations attainable by the CZ process) and time. Stated another way, the concentration of precipitation sites may simply be increased by increasing the rapid thermal annealing temperature and, since a rapid thermal annealer is used, the incremental time required to achieve greater temperatures is a matter of only seconds.

Accordingly, thermal donor formation in the denuded zone in a subsequent device fabrication process may be controlled, in part, by selection of a rapid thermal annealing temperature (which determines the concentration of oxygen precipitation sites) and by controlling the thickness of the denuded zone which will form in a subsequent oxygen precipitation heat-treatment. As described in greater detail below, the present invention enables the thickness of the denuded zone to be controlled, in part, by the composition of the ambient selected for the rapid thermal annealing step, and the cooling rate from the temperature of the rapid thermal anneal to temperatures at which crystal lattice vacancies are, as a practical matter, immobile. In one embodiment, the conditions of the thermal-treatment and cooling are controlled to create a template for the formation of a thin or shallow denuded zone (e.g., a denuded zone of less than about 30 microns). By enabling a thin denuded zone to be obtained, the present process advantageously acts to position the interstitial oxygen therein in close proximity to the wafer bulk and surface, where it may ultimately be consumed.

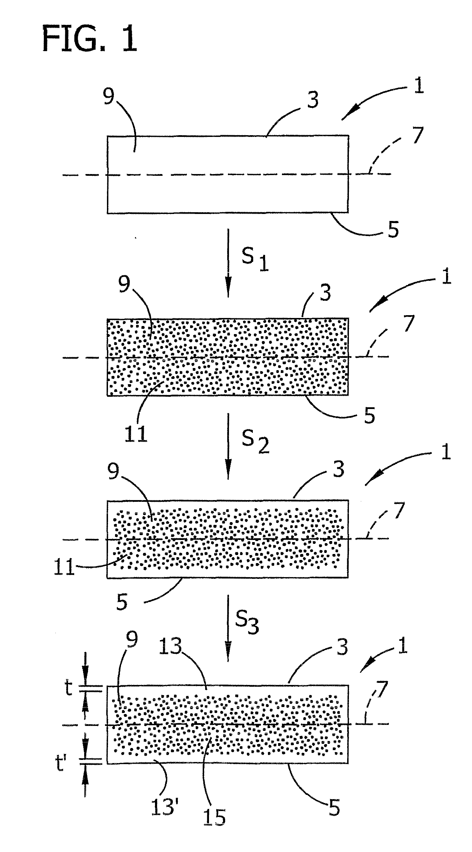

Referring now to Fig. 1, the starting material for the present process is a single crystal silicon wafer **1,** having a front surface **3,** a back surface **5,** an imaginary central plane **7** between the front and back surfaces, and a wafer bulk **9** comprising the wafer volume between the front and back surfaces. The terms "front" and "back" in this context are used to distinguish the two major, generally planar surfaces of the wafer; the front surface of the wafer as that term is used herein is not necessarily the surface onto which an electronic device will subsequently be fabricated nor is the back surface of the wafer as that term is used herein necessarily the major surface of the wafer which is opposite the surface onto which the electronic device is fabricated. In addition, because silicon wafers typically have some total thickness variation, warp and bow, the midpoint between every point on the front surface and every point on the back surface may not precisely fall within a plane; as a practical matter, however, the TTV, warp and bow are typically so slight that to a close approximation the midpoints can be said to fall within an imaginary central plane which is approximately equidistant between the front and back surfaces.

In general, in step **S₁** of the process, the silicon wafer **1** is subjected to a heat-treatment step in which the wafer is heated to an elevated temperature to form and thereby increase the number density of crystal lattice vacancies **11** in wafer 1. Preferably, this heat-treatment step is carried out in a rapid thermal annealer in which the wafer is rapidly heated to a target temperature and annealed at that temperature for a relatively short period of time. In general, the wafer is subjected to a temperature in excess of 1175°C, typically at least about 1200°C and, in one embodiment, between about 1200°C and 1300°C. The wafer will generally be maintained at this temperature for at least one second, typically for at least several seconds (e.g., at least 3, 5, etc.) or even several tens of seconds (e.g., at least 20, 30, 40, etc.) and, depending upon the desired characteristics of the wafer and the atmosphere in which the wafer is being annealed, for a period which may range up to about 60 seconds (which is near the limit for commercially available rapid thermal annealers).

Upon completion of the rapid thermal annealing step, the wafer, in step **S₂**, is rapidly cooled through the range of temperatures at which crystal lattice vacancies are relatively mobile in the single crystal silicon, vacancies typically being mobile in silicon within a commercially practical period of time down to temperature in excess of about 700°C, 800°C, 900°C or even 1000°C. As the temperature of the wafer is decreased through this range of temperatures, some vacancies recombine with silicon self-interstitial atoms and others diffuse to the front surface **3** and back surface **5,** thus leading to a change in the vacancy concentration profile with the extent of change depending upon the length of time the wafer is maintained at a temperature within this range. If the wafer were slowly cooled, the vacancy concentration would once again become substantially uniform throughout wafer bulk **9** with the concentration being an equilibrium value which is substantially less than the concentration of crystal lattice vacancies immediately upon completion of the heat treatment step.

However, as further described herein, by rapidly cooling the wafer, either alone or in conjunction with control of the ambient in which the wafer is heat-treated and cooled, a non-uniform distribution of crystal lattice vacancies can be achieved, the concentration in the wafer bulk being greater than the concentration in a region near the surface. For example, process conditions (e.g., cooling rate) may be controlled, for example, such that the maximum vacancy concentration is a distance of at least about 20 micrometers, 30 micrometers, 40 micrometers, 50 micrometers or more from the wafer surface. In one embodiment, the maximum vacancy concentration is at or near a central plane **7,** the vacancy concentration generally decreasing in the direction of the front surface **3** and back surface **5** of the wafer. In a second embodiment, the maximum vacancy concentration is between the central plane **7** and a layer or region near the surface **3** and/or **5** of the wafer (as further described herein), the concentration generally decreasing in the direction of both the surface and the central plane.

In general, the average cooling rate within the range of temperatures in which vacancies are mobile is at least about 5°C per second, while in some embodiments the rate is preferably at least about 20°C per second, 50°C per second, 100°C per second or more, with cooling rates in the range of about 100°C to about 200°C per being particularly preferred in some instances. In this regard it is to be noted that, once the wafer is cooled to a temperature outside the range of temperatures at which crystal lattice vacancies are relatively mobile in the single crystal silicon, the cooling rate does not appear to significantly influence the precipitating characteristics of the wafer and thus does not appear to be narrowly critical.

The rapid thermal annealing and cooling steps may be carried out in, for example, any of a number of commercially available rapid thermal annealing ("RTA") furnaces in which wafers are individually heated by banks of high power lamps. RTA furnaces are capable of rapidly heating a silicon wafer, for example, from room temperature to about 1200°C in a few seconds. Additionally, as further described herein below, they may be used to anneal and cool the wafer in a number of different ambients or atmospheres, including those containing oxygen (e.g., elemental oxygen gas, pyrogenic steam, etc.), nitrogen (e.g., elemental nitrogen gas or a nitrogen-contain compound gas such as ammonia), a non-oxygen, non-nitrogen containing gas (e.g., an inert gas like helium or argon), or a mixture or combination thereof.

After an oxygen precipitation heat-treatment step, S₃, in which the wafer is annealed, for example, at a temperature of about 800°C for at least about two hours and then at a temperature of about 1000°C for about sixteen hours in an oxygen containing atmosphere, the resulting depth distribution of oxygen precipitates in the wafer is characterized by clear regions of oxygen precipitate-free material (precipitate free zones or "denuded zones") 13 and 13' extending from the front surface 3 and back surface 5 to a depth t, t' respectively. Between these oxygen precipitate-free regions, is a precipitation zone 15 containing, for example, (i) in a first embodiment (which corresponds to the first embodiment of the vacancy concentration profile described above) a substantially uniform density of oxygen precipitates in the wafer bulk, or (ii) in a second embodiment (which corresponds to the second embodiment of the vacancy concentration profile described above) an oxygen precipitate profile wherein the maximum density is between a surface layer and the central plane. In general, the density of precipitates will be greater than about 10⁸ and less than about 10¹¹ precipitates/cm³, with precipitate densities of about 5x10⁹ or 5 x 10¹⁰ being typical in some embodiments.

The depths **t, t'** from the front and back surfaces, respectively, of oxygen precipitate-free material (denuded) zones **13** and **13'** are, in part, a function of the cooling rate through the temperature range at which crystal lattice vacancies are relatively mobile in silicon. In general, the depth **t, t'** decreases with decreasing cooling rates, with denuded zone depths of about 10, 20, 30, 40, 50 microns or more (e.g., 70, 80, 90, 100) being attainable. As a practical matter, however, the cooling rate required to obtain shallow denuded zone depths are somewhat extreme and the thermal shock may create a risk of shattering the wafer. Alternatively, therefore, the thickness of the denuded zone may be controlled by selection of the ambient in which the wafer is annealed while allowing the wafer to cool at a less extreme rate. Stated another way, for a given cooling rate, an ambient may be selected which creates a template for a deep denuded zone (e.g., 50+ microns), intermediate denuded zones (e.g., 30-50 microns), shallow denuded zones (e.g., less than about 30 microns), or even no denuded zone. Experience to-date indicates:
1. When a non-nitrogen, non-oxygen-containing gas is used as the atmosphere or ambient in the rapid thermal annealing step and cooling step, the increase in vacancy concentration throughout the wafer is achieved nearly, if not immediately, upon achieving the annealing temperature. The profile of the resulting vacancy concentration (number density) in the cooled wafer is relatively constant from the front of the wafer to the back of the wafer. Maintaining the wafer at an established temperature during the anneal for additional time does not appear, based upon experimental evidence obtained to-date, to lead to an increase in vacancy concentration. Suitable gases include argon, helium, neon, carbon dioxide, and other such inert elemental and compound gasses, or mixtures of such gasses.
2. When a nitrogen-containing atmosphere or ambient is used as the atmosphere in the thermal annealing and cooling steps of the first embodiment, vacancy concentration appears to increase as a function of time at an established annealing temperature. The resulting wafer will have a vacancy concentration (number density) profile which is generally "U-shaped" for a cross-section of the wafer; that is, after cooling, a maximum concentration will occur at or within several micrometers of the front and back surfaces and a relatively constant and lesser concentration will occur throughout the wafer bulk. Hence, the depth of a denuded zone, formed in an oxygen precipitation heat treatment, approaches zero. In addition to nitrogen gas (N₂), nitrogen-containing gases such as ammonia are suitable for use.
3. When the atmosphere or ambient in the rapid thermal annealing and cooling steps contains oxygen, or more specifically when it comprises oxygen gas (O₂) or an oxygen-containing gas (e.g., pyrogenic steam) in combination with a nitrogen-containing gas, an inert gas or both, the vacancy concentration profile in the near surface region is affected. Experimental evidence to-date indicates that the vacancy concentration profile of a near-surface region bears an inverse relationship with atmospheric oxygen concentration. Without being bound to any particular theory, it is generally believed that, in sufficient concentration, annealing in oxygen results in the oxidation of the silicon surface and, as a result, acts to create an inward flux of silicon self-interstitials. The flux of silicon interstitials is controlled by the rate of oxidation which, in turn, can be controlled by the partial pressure of oxygen in the ambient. This inward flux of self-interstitials has the effect of gradually altering the vacancy concentration profile by causing recombinations to occur, beginning at the surface and then moving inward, with the rate of inward movement increasing as a function of increasing oxygen partial pressure. When oxygen is used in combination with a nitrogen-containing gas in the ambient during heat-treatment (**S₁**) and cooling (**S₂**), a "M-shaped" vacancy profile may be obtained, wherein the maximum or peak vacancy concentration is present in the wafer bulk between the central plane and a surface layer (the concentration generally decreasing in either direction). Such a profile may alternatively be obtained by first heat-treating a wafer in a nitriding or nitrogen-containing ambient and then heat-treating in an oxidizing or oxygen-containing ambient, after cooling the U-shaped profile (as previously described above) becoming M-shaped by the inward flux of interstitials.
   As a result of the presence of oxygen in the ambient, a region of low vacancy concentration may be created which, following an oxygen precipitation heat treatment, in turn results in the formation of a denuded zone of any arbitrary depth suitable for a particular end use of a device which is to be fabricated from the silicon wafer.

In one embodiment, therefore, the atmosphere during the rapid thermal annealing and cooling steps process typically contains an oxygen partial pressure sufficient to obtain a denuded zone depth of less than about 30 microns, and preferably a denuded zone depth ranging from greater than about 5 microns to less than about 30 microns, from about 10 microns to about 25 microns, or from about 15 microns to about 20 microns. More specifically, the annealing and cooing steps of the present process are typically carried out in an atmosphere comprising (i) a nitrogen-containing gas (e.g., N₂), (ii) a non-oxygen, non-nitrogen containing gas (e.g., argon, helium, etc.), or (iii) a mixture thereof, and (iv) an oxygen-containing gas (e.g., O₂ or pyrogenic steam), the atmosphere having an oxygen partial pressure sufficient to create an inward flux of interstitials (e.g., at least about 1 PPMA, 5 PPMA, 10 PPMA or more) but less than about 500 PPMA, preferably less than about 400 PPMA, 300 PPMA, 200 PPMA, 150 PPMA or even 100 PPMA, and in some embodiments preferably less than about 50, 40, 30, 20 or even 10 PPMA. When a mixture of a nitrogen-containing and a non-nitrogen, non-oxygen containing gas is used with the oxidizing gas, the respective ratio of the two (i.e., nitrogen-containing to inert gas) may range from about 1:10 to about 10:1, from about 1:5 to about 5:1, from about 1:4 to about 4:1, from about 1:3 to about 3:1, or from about 1:2 to about 2:1, with ratios of nitrogen-containing gas to inert gas of about 1:5, 1:4, 1:3, 1:2 or 1:1 being preferred in some embodiments. Stated another way, if such a gaseous mixture is used as the atmosphere for the annealing and cooling steps, the concentration of nitrogen-containing gas therein may range from about 1% to less than about 100%, from about 10% to about 90%, from about 20% to about 80% or from about 40% to about 60%.

In this regard it is to be noted that the precise conditions for the annealing and cooling steps may be other than herein described without departing from the scope of the present invention. Furthermore, such conditions may be determined, for example, empirically by adjusting the temperature and duration of the anneal, and the atmospheric conditions (i.e., the composition of the atmosphere, as well as the oxygen partial pressure) in order to optimize the desired depth of **t** and/or **t'**.

Regardless of the precise profile, the wafer of the present invention can be said to possess a template for oxygen precipitation well-suited for applications requiring a silicon wafer having a thin or shallow denuded zone therein. In the high vacancy concentration regions, i.e., the wafer bulk, oxygen clusters rapidly as the wafer is subjected to an oxygen precipitation heat-treatment. In the low vacancy concentration regions, i.e., the near-surface regions, however, the wafer behaves like a normal wafer which lacks pre-existing oxygen precipitate nucleation centers when the wafer is subjected to this oxygen precipitation heat-treatment; that is, oxygen clustering is not observed and some out-diffusion of oxygen occurs. As the temperature is increased above 800°C, or if the temperature remains constant, the clusters in the vacancy rich zone grow into precipitates and are thereby consumed. By dividing the wafer into various zones of vacancy concentration, a template is effectively created through which is written an oxygen precipitate pattern which is fixed the moment the wafer is loaded into the furnace for an oxygen-precipitation heat-treatment.

In this regard it is to be noted that, while the heat treatments employed in the rapid thermal anneal process may result in the out-diffusion of a small amount of oxygen from the surface of the front and back surfaces of the wafer, the wafer bulk will have a substantially uniform oxygen concentration as a function of depth from the silicon surface. For example, the wafer will have a uniform concentration of oxygen from the center of the wafer to regions of the wafer which are within about 15 micrometers of the silicon surface, more preferably from the center of the silicon to regions of the wafer which are within about 10 micrometers of the silicon surface, even more preferably from the center of the silicon to regions of the wafer which are within about 5 micrometers of the silicon surface and most preferably from the center of the silicon to regions of the wafer which are within 3 micrometers of the silicon surface. In this context, substantially uniform oxygen concentration shall mean a variance in the oxygen concentration of no more than about 50%, preferably no more than about 20% and most preferably no more than about 10%.

In this regard it is to be further noted that, in general, a denuded zone is a zone occupying the region near the surface of a wafer which has (i) an absence of oxygen precipitates in excess of the current detection limit (currently about 10⁷ oxygen precipitates/cm³) and (ii) a low concentration of, and preferably an essential absence of oxygen precipitation centers which, upon being subjected to an oxygen precipitation heat-treatment, are converted to oxygen precipitates. The presence (or density) of oxygen precipitate nucleation centers cannot be directly measured using presently available techniques. They may be indirectly measured, however, if they are stabilized and oxygen precipitates are grown at these sites by subjecting the silicon to an oxygen precipitation heat treatment. As used herein, therefore, silicon having a low density of oxygen precipitate nucleation centers shall mean silicon which, upon being annealed at a temperature of 800°C for four hours and then at a temperature of 1000°C for sixteen hours, has less than about 10⁸ oxygen precipitates/cm³. Similarly, silicon having an essential absence of oxygen precipitate nucleation centers shall mean silicon which, upon being annealed at a temperature of 800°C for four hours and then at a temperature of 1000°C for sixteen hours, has less than 10⁷ oxygen precipitates/cm³.

In view of the foregoing, it can be seen that, advantageously, the wafers of the present invention have a template for oxygen precipitation which enables the reliable, reproducible and efficient formation of a denuded zone in a near-surface region (e.g., less than about 30 microns from the wafer surface) of the wafer, and a desirable number of microdefects (oxygen precipitates) in the wafer bulk for internal gettering (e.g., at least about 1 x 10⁸ cm⁻³). Such wafers are suitable for use in various applications directly, or they may be used as a substrate or a component of some other wafer or device, as further described herein below.

Additionally, the present process enables the preparation of such wafers wherein at least the surface layer has a relatively low interstitial oxygen concentration (e.g., less than about 10 PPMA, 9 PPMA, 8 PPMA, 7 PPMA, 6 PPMA or even 5 PPMA), whether achieved by selecting a wafer sliced from an ingot having a relatively low oxygen concentration initially, by annealing the wafer to reduce the interstitial oxygen concentration after the template for oxygen precipitation is established, or by optionally controlling the denuded zone depth. As a result, the present process may be used to prepare wafers that will not form thermal donors in the surface layer in an amount sufficient to appreciably affect the resistivity of the wafers during a typical semiconductor device fabrication process.

### C. Epitaxial Layer

In one embodiment of the present invention, an epitaxial layer may be deposited upon the surface of an ideal precipitating wafer having a relatively low interstitial oxygen concentration. The epitaxial layer will be formed by means conventionally known and used by those skilled in the art such as decomposition of a gas phase, silicon-containing composition. In a preferred embodiment of this invention, the surface of the wafer is exposed to an atmosphere comprising a volatile gas comprising silicon (e.g., SiCl₄, SiHCl₃, SiH₂Cl₂, SiH₃Cl or SiH₄). The atmosphere also preferably contains a carrier gas (preferably H₂). In one embodiment, the source of silicon during the epitaxial deposition is SiH₂Cl₂ or SiH₄. If SiH₂Cl₂ is used, the reactor vacuum pressure during deposition preferably is from about 500 to about 760 Torr. If, on the other hand, SiH₄ is used, the reactor pressure preferably is about 100 Torr. Most preferably, the source of silicon during the deposition is SiHCl₃. This tends to be much cheaper than other sources. In addition, an epitaxial deposition using SiHCl₃, may be conducted at atmospheric pressure. This is advantageous because no vacuum pump is required and the reactor chamber does not have to be as robust to prevent collapse. Moreover, fewer safety hazards are presented and the chance of air or other gases leaking into the reactor chamber is lessened.

During the epitaxial deposition, the wafer surface preferably is maintained at a temperature sufficient to prevent the atmosphere comprising silicon from depositing polycrystalline silicon onto the surface a temperature of at least about 800°C, more preferably about 900°C, and most preferably about 1100°C. The rate of growth of the epitaxial deposition preferably is from about 0.5 to about 7.0 µm/min. A rate of from about 3.5 to 4.0 µm/min. may be achieved, for example, by using an atmosphere consisting essentially of about 2.5 mole% SiHCl₃ and about 97.5 mole% H₂ at a temperature of about 1150°C and pressure of about 1 atmosphere.

If desired, the epitaxial layer may additionally include a p-type or n-type dopant. For example, it is often preferable for the epitaxial layer to contain boron. Such a layer may be prepared by, for example, including B₂H₆ in the atmosphere during the deposition. The mole fraction of B₂H₆ in the atmosphere used to obtain the desired properties (*e.g.,* resistivity) will depend on several factors, such as the amount of boron out-diffusion from the particular substrate during the epitaxial deposition, the quantity of p-type dopants and n-type dopants that are present in the reactor and substrate as contaminants, and the reactor pressure and temperature. For high resistivity applications, the dopant concentration in the epitaxial layer is preferably as low as practical (the substrate wafer of the present invention optionally having a high or low resistivity, or a respective resistivity greater than or less than about 50 ohm cm).

### D. Silicon on Insulator Structure

A silicon on insulator structure generally comprises a device layer, a handle wafer or supporting layer, and an insulating film or layer (typically an oxide layer) between the supporting layer and the device layer. Generally, the device layer is between about 0.5 and 20 micrometers thick. Silicon on insulator structures may be prepared using various techniques known in the art, as further described herein below.

If the support layer of the SOI structure comprises or is derived from a wafer of the present invention, preferably the present wafer process will be carried out before the device layer of the SOI structure has been attached to the handle wafer (or, in the case of ion implantation processes, before implantation occurs). If the present process is carried out prior to formation of the SOI structure, it may be desirable to stabilize the oxygen precipitate nucleation centers in the handle wafer after the process is complete and before preparation of the SOI structure begins. Additionally, if this approach is employed, the oxygen precipitation heat treatment of step **S₃** may, in some embodiments, be achieved during formation of the SOI structure (such as in the case of wafer bonding), provided the treatment time and temperature employed by the SOI process are sufficient for oxygen precipitate formation.

It is to be further noted, however, that the present silicon wafer process may also be performed after the SOI structure has been prepared. Without being held to any particular theory, it is believed that the SOI structure will behave as a typical single crystal silicon wafer, with the oxide layer acting as a free surface from which vacancies and self-interstitials may be injected and to which they may diffuse.

SOI structures may be prepared, for example, by the SIMOX process by subjecting the wafer of the present invention to an ion implantation process which, as noted above, is standard in the art. (See, e.g., U.S. Patent No. 5,436,175 and Plasma Immersion Ion Implantation for Semiconductor Processing, Materials Chemistry and Physics 46 (1996) 132-139, both of which are incorporated herein by reference). In such a process, the ions are implanted into a silicon wafer substrate which is then subjected to a high temperature anneal to form a buried oxide, insulating layer. If, for example, oxygen ions are implanted, a buried insulating layer of silicon dioxide (SiO₂) is formed, If nitrogen atoms are implanted, a buried layer of silicon nitride (Si₃N₄) is formed. In such instances, the resulting SOI structure comprises a device layer and an insulating layer, both derived from a wafer of the present invention. Because of the high temperature oxide formation anneal, typically about 1150°C to about 1400°C, oxygen solubility exceeds the typical oxygen concentration in the wafer so that preexisting precipitates may dissolve back into interstitial oxygen. In such instances, for some application an oxygen reduction secondary anneal may be preformed following the SIMOX process. This embodiment, then, typically comprises: performing the rapid thermal anneal and cooling process on a single crystal silicon wafer having essentially any oxygen concentration attainable using Cz crystal pulling techniques; forming an oxide insulating layer in the wafer; and, performing a secondary anneal at a temperature in the range of 700°C to about 1100°C.

SOI structures may also be prepared by bonding two wafers and removing a portion of one of the bonded wafers. For example, SOI structures can be prepared by the BESOI process, wherein the wafer of the present invention is bonded to another wafer, and then a substantial portion of one of the wafers is etched away using known wafer thinning techniques to obtain the device layer. (See, e.g., U.S. Patent Nos. 5,024,723 and 5,189,500 which are incorporated herein by reference.) In this instance, the resulting SOI structure comprises (i) a device layer, (ii) a handle wafer or supporting layer, and (iii) an insulating layer between the device layer and the support layer.

In an alternative wafer bonding approach, hydrogen or another ion is implanted into one of the wafers and, after the two wafers are bonded, the bonded composite is subjected to a force which causes the bonded composite to cleave at the implantation site. For example, a SOI structure may be prepared by (1) the implantation of ions (e.g., hydrogen, nitrogen, etc.) in a wafer of the present invention by bombardment to produce a layer of gaseous microbubbles, while keeping the temperature below the temperature at which the gaseous microbubbles can escape therefrom by diffusion, (2) contacting the planar face of the wafer with a stiffener to form a bonded composite, and (3) subjecting the bonded composite to a thermal or mechanical stress which causes the wafer of the present invention to delaminate in the region of ion implantation. If thermal stress is used, the composite is heated to a temperature above that which the implantation of ions occurred in order to create a crystalline rearrangement and a pressure effect in the microbubbles resulting in a separation between the thin semiconductor film and the majority of the substrate (See, e.g., U.S. Pat. No. 5,374,564 which is incorporated herein by reference). If the SOI structure is to comprise a wafer of the present invention as a stiffener, in one embodiment, the wafer is subjected to the ideal precipitating process described above before bonding to the planar face of the other wafer. In another embodiment, the low defect density silicon wafer may first be bound to a Czochralski-type single crystal silicon wafer, and then the entire SOI structure may be subjected to the ideal precipitating process described above.

Accordingly, the silicon on insulator structures of the present invention are derived from a silicon wafer of the present invention. More specifically:
1. In one embodiment, the SOI structure comprises a device layer, a supporting layer and an insulating layer there between. The supporting layer comprises (A) an imaginary plane centrally located therein, a first stratum and a second stratum, the second stratum comprising the central plane, the first stratum extending from the insulating layer to the second stratum and having a thickness, T₁, as measured from the insulating layer to the second stratum, and (B) a non-uniform concentration of crystal lattice vacancies in which a peak concentration is in the second stratum between the first stratum and the central plane, the concentration generally decreasing in either direction, wherein (i) T₁ is at least about 5 microns but less than about 30 microns, and (ii) upon being subjected to an oxygen precipitation heat-treatment at a temperature in excess of about 700°C, the first stratum has an oxygen precipitate density of less than about 1 x 10⁷ cm⁻³ while the second stratum has an oxygen precipitate density of greater than about 1 x 10⁷ cm⁻³. In alternative embodiments, T₁ may range from at least about 5 microns to less than about 25, 20, 15 or even 10 microns (e.g., from about 10 to 25 microns, or from about 15 to 20 microns).
2. In a second embodiment, the SOI structure comprises a silicon wafer, sliced from a single crystal silicon ingot grown in accordance with the Czochralski method. The silicon wafer has (A) a front surface, a back surface, an imaginary central plane approximately equidistant between the front and back surfaces, (B) a surface stratum which comprises a region of the wafer between the front surface and a distance, D, measured from the front surface and toward the central plane, and which includes a device layer and an insulating layer, the device layer extending from the front surface to the insulating layer, (C) a bulk stratum which comprises the imaginary central plane but not the first stratum, and (D) a non-uniform concentration of crystal lattice vacancies in which a peak concentration is in the bulk stratum between the central plane and the surface stratum, wherein (i) D is at least about 5 microns but less than about 30 microns, and (ii) upon being subjected to an oxygen precipitation heat-treatment at a temperature in excess of about 700°C, the surface stratum has an oxygen precipitate density of less than about 1 x 10⁷ cm⁻³ and the bulk stratum has an oxygen precipitate density of greater than about 1 x 10⁷ cm⁻³.
In alternative embodiments, D may range from at least about 5 microns to less than about 25, 20, 15 or even 10 microns (e.g., from about 10 to 25 microns, or from about 15 to 20 microns).

### E. Additional Embodiments

It is to be noted that, in addition to the embodiments described herein above, the process generally described herein for controlling the vacancy concentration profile in a Czochralski-type single crystal silicon wafer may alternatively be used to prepare silicon wafers having a thin or shallow surface layer or region which is essentially oxygen-precipitate free ("denuded") by, for example:
1. Thermally annealing the silicon wafer, as described herein, in an atmosphere of pure nitrogen, or some other purely nitriding gas, in order to obtain a substantially uniform, high vacancy concentration throughout the wafer; that is, such a thermal anneal may be utilized to obtain a wafer having a high vacancy concentration which is substantially constant from the front surface of the wafer to the back surface (assuming neither surface has been shielded in some way). Coupled with an oxygen precipitation heat-treatment and an appropriate epitaxial layer, or alternatively a device layer of some kind (such as in the case of a silicon on insulator structure), a wafer can be obtained which has a surface layer or region of a desired depth which is substantially free of oxygen precipitates.
   Alternatively, after thermally annealing in a nitriding atmosphere or ambient, and thus creating such a high vacancy concentration throughout the wafer, the wafer may be subjected to an anneal in an oxidizing atmosphere (either after the wafer has cooled or at temperature), thus altering the high vacancy profile by means of creating an inward flux of interstitials (as described herein), the vacancies being consumed through recombination.
2. Increasing the cooling rate after the thermal anneal, in order to achieve a thin (e.g., less than about 30 microns) denuded zone.
3. After thermally annealing and cooling the wafer to obtain a thick denuded zone (e.g., greater than about 30 microns), removing a portion thereof by means known in the art (e.g., wafer polishing).

Additionally, it is to be noted that one or more of such embodiments presented herein may be suited for applications wherein the denuded zone has essentially any resistivity (e.g., less than about 50 ohm cm, or greater than about 50 ohm cm, 100 ohm cm, 300 ohm cm, 500 ohm cm or more); that is, one or more of the embodiment described herein may be for wafers having a low resistivity (i.e., a resistivity of less than about 50 ohm cm).

### EXAMPLES

The following examples will illustrate the various features of the present invention.

### Example 1

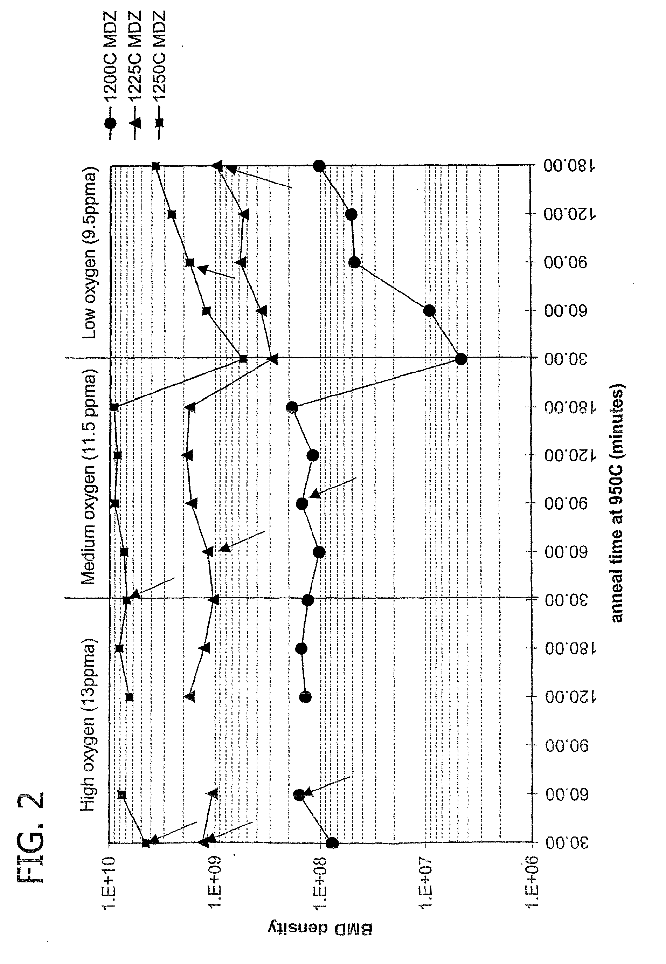

Example 1 and Fig. 2 demonstrate the gettering capability of ideal precipitating wafers over a range of oxygen concentration. In the first set of experiments, ideal precipitating wafers with an oxygen concentration of 13 PPMA were produced at a step S₁ heat treatment temperature of 1200°C, followed by oxygen bulk precipitate growth at 950°C over a range of 30 minutes to 180 minutes. The evaluations were repeated for 1225°C and 1250°C step S₁ heat treatment temperatures. In a second and third set of experiments, the first set of experiments were repeated for ideal precipitating wafers with oxygen concentrations of 11.5 PPMA and 9.5 PPMA respectively. Gettering capability was measured by contaminating the wafer back surface with nickel. The arrows in Fig. 2 indicate the onset of complete gettering. The data show that bulk precipitate density above the threshold for effective gettering may be obtained for ideal precipitating wafers over a range of oxygen concentration, and even in the case of low oxygen concentration.

### Example 2

Four wafers were cut from two sections of a high resistivity CZ crystal. Three wafers were given ideal precipitating wafer heat-treatments at 1235°C, 1250°C and 1275°C, respectively. The fourth wafer was a control that was not given an ideal precipitating wafer heat-treatment. Each wafer was then quartered and given the following secondary anneals:
- Wafer GG, Quarter 1 (GGQ1):: 4 hours at 800°C followed by 16 hours at 1000°C;
- Wafer GG, Quarter 2 (GGQ2):: 8 hours at 800°C followed by 16 hours at 1000°C;
- Wafer GG, Quarter 3 (GGQ3):: ramp from 800°C to 1000°C at 1 °C/min followed by 1 hour at 1000°C; and
- Wafer GG, Quarter 4 (GGQ4):: ramp from 800°C to 1000°C at 2°C/min followed by 1 hour at 1000°C.

Following the secondary anneals, the BMD density was measured by OPP (Optical Precipitate Profiler). The OPP method is an applied method of Normalski type differential interference microscope. In the method, laser beam from light source is separated to two orthogonal polarized straight beams of which phases are 90 degree different from each other through use of a polarizing prism, which then enter the wafer from the side of mirror polished surface. At this time, when one of the beams crosses a defect, phase shift occurs to form phase contrast with the other beam. The defect is detected by detecting the phase contrast with a polarization analyzer after the beams transmit from the back surface of the wafer. The results are shown in the table below.

| Wafer | BMD Density/cm³ |
|---|---|
| GG Control Q1 | 3.9 x 10⁸ |
| GG Control Q2 | 1.3 x 10⁸ |
| GG Control Q3 | 2.5 x 10⁸ |
| GG Control Q4 | --- |
| GGQ1 (1235) | 6.7 x 10⁹ |
| GGQ2 (1235) | 8.0 x 10⁹ |
| GGQ3 (1235) | 2.5 x 10⁷ |
| GGQ4 (1235) | 2.9 x 10⁷ |
| GGQ1(1250) | 9.3 x 10⁹ |
| GGQ2 (1250) | 1.1 x 10¹⁰ |
| GGQ3 (1260) | 4.9 x 10⁸ |
| GGQ4(1250) | 4.5 x 10⁷ |
| GGQ1 (1275) | 1.2 x 10¹⁰ |
| GGQ2 (1275) | 1.1 x 10¹⁰ |
| GGQ3 (1275) | 3.0 x 10⁸ |
| GGQ4 (1275) | 6.7 x 10⁷ |

The control wafers did not receive an ideal precipitating wafer treatment thus the precipitate density following the thermal cycles is due to pre-existing precipitates which grew during the various thermal cycles. For wafers subjected to an ideal precipitating wafer treatment, there is a large difference in BMD density between the Q1 and Q2 (fixed temperature 800°C + 1000°C) anneals as compared to the Q3 and Q4 (ramped temperature) anneals. The 800°C + 1000°C anneals were efficient in growing the BMDs to a size where they are detectable by OPP. In contrast, the ramped anneals from 800°C to 1000°C were not very efficient at growing the precipitates. The results also indicate that the BMD density after the 800°C + 1000°C anneal increases with increasing ideal precipitating wafer anneal temperature.

### Example 3

The radial initial and final oxygen concentration (Oᵢ) of the annealed GG wafers from Example 2, a second set of wafers (GA) prepared as in Example 2, and corresponding untreated GG and GA wafers was determined. The results, reported in Oᵢ (PPMA) at radial distances from the wafer (mm) for the annealed wafers with the indicated ideal precipitating wafer treatment temperature in parentheses, are given in the table below.

| Wafer | 10 mm | 30mm | 50 mm | 70 mm | 90 mm |
|---|---|---|---|---|---|
| GG initial | 12.2 | 12.1 1 | 12.0 | 11.9 | 11.5 |
| GA initial | 11.2 | 11.0 | 10.9 | 10.9 | 10.5 |
| GGQ1(1235) | 9.0 | 8.6 | 8.7 | 8.9 | 9.0 |
| GGQ2 (1235) | 7.9 | 7.5 | 7.6 | 7.8 | 8.1 1 |
| GGQ3 (1235) | 12.0 | 12.0 | 11.9 | 11.7 | 11.5 |
| GGQ4 (1235) | 12.6 | 12.0 | 12.0 | 11.9 | 11.6 |
| GAQ1 (1235) | 9.5 | 9.0 | 9.1 | 9.1 | 9.2 |
| GAQ2 (1235) | 8.3 | 8.0 | 8.2 | 8.3 | 8.6 |
| GAQ3 (1235) | 11.1 | 11.0 | 10.8 | 10.8 | 10.4 |
| GAQ4 (1235) | 11.1 | 11.0 | 10.8 | 10.8 | 10.5 |
| GGQ1 (1250) | 7.6 | 7.4 | 7.4 | 7.6 | 8.0 |
| GGQ2 (1250) | 6.1 | 5.9 | 5.9 | 6.0 | 6.5 |
| GGQ3(1250) | 12.2 | 12.0 | 12.0 | 11.9 | 11.5 |
| GGQ4 (1250) | 12.2 | 12.1 | 12.1 | 12.0 | 11.5 |
| GAQ1 (1250) | 8.5 | 8.2 | 8.3 | 8.4 | 8.6 |
| GAQ2 (1250) | 6.9 | 6.6 | 6.6 | 6.8 | 7.3 |
| GAQ3 (1250) | 11.0 | 10.9 | 10.9 | 10.8 | 10.5 |
| GAQ4 (1250) | 11.1 | 10.9 | 11.0 | 10.9 | 10.5 |
| GGQ1 (1275) | 5.7 | 5.4 | 5.6 | 5.8 | 6.0 |
| GGQ2 (1275) | 4.1 | 4.0 | 4.2 | 4.4 | 4.5 |
| GGQ3 (1275) | 12.2 | 12.0 | 11.8 | 11.7 | 11.6 |
| GGQ4 (1275) | 12.4 | 12.3 | 12.1 | 11.9 | 11.8 |
| GAQ1 (1275) | 6.9 | 6.8 | 6.9 | 7.0 | 7.3 |
| GAQ2 (1275) | 5.1 | 5.0 | 5.1 | 5.3 | 5.6 |
| GAQ3 (1275) | 11.0 | 10.9 | 10.9 | 10.8 | 10.5 |
| GAQ4 (1275) | 11.2 | 11.0 | 10.9 | 10.8 | 10.5 |

The 800°C to 1000°C ramped anneals (Q3 and Q4) are not very efficient in growing the precipitates formed during the ideal precipitating wafer process, resulting in very little removal of interstitial oxygen from solution. In contrast, the two step 800°C and 1000°C anneals (Q1 and Q2) are much more effective in growing the precipitates formed during the ideal precipitating wafer process and in removing interstitial oxygen from solution. Further, the 8 hour/800°C anneal is more effective at interstitial oxygen removal than the 4 hour/800°C anneal. Moreover, the final Oᵢ after the two step anneal decreases with increasing ideal precipitating wafer high temperature anneal temperature. Finally, the data show that the final Oᵢ is a function of the initial Oᵢ, with a higher initial Oᵢ providing greater supersaturation which leads to a greater amount of removal of interstitial oxygen from solution during the secondary anneals.

### Example 4

This example illustrates the trend that may be observed in the depth of the denuded zone resulting from an increase in the oxygen concentration in the ambient atmosphere employed in a standard ideal precipitating wafer thermal cycle at a **S**₁ temperature of 1250°C (15 second anneal). The wafers in Set A were annealed in an argon/nitrogen/oxygen-containing atmosphere, and the wafers in Set B were annealed in a nitrogen/oxygen-containing atmosphere (the partial pressure of oxygen varying). After the process was complete, BMD density and denuded zone depth were determined by means known in the art. The results are given in the table below.

| Wafer Set | O₂ partial pressure (PPMA) | DZ depth (microns) |
|---|---|---|
| A | 0 | 4 |
| A | 40 | 9 |
| A | 100 | 15 |
| A | 200 | 32 |
| A | 400 | 64 |
| A | 1000 | 74 |
| A | 2000 | 80 |
| B | 0 | 7 |
| B | 40 | 4 |
| B | 100 | 4 |
| B | 200 | 7 |
| B | 400 | 53 |
| B | 1000 | 60 |
| B | 2000 | 75 |

The data show that a combination of nitrogen/oxygen, or argon/nitrogen/oxygen may be used as the annealing (and optionally cooling) ambient during ideal precipitating wafer treatment to produce wafers of predetermined DZ depth; stated another way, the results show that the denuded zone depth may be "tuned" by adjusting the concentration of oxygen in the atmosphere (the denuded zone depth decreasing as the oxygen content increases).

Additionally, it is to be noted that results from these experiments (not shown) also indicate that even a small partial pressure of nitrogen (e.g., less than about 5%, 3% or even 2%) in an argon atmosphere, when no oxygen is present, results in no denuded zone. Therefore, a partial pressure of nitrogen in argon can range from less than about 1% to about 100%. However, experience to-date suggests a concentration of about 25% to 75% nitrogen in argon may allow for more precise control of denuded zone depth (in combination with a controlled oxygen concentration).

In view of the above, it will be seen that the several objects of the invention are achieved. As various changes could be made in the above compositions and processes without departing from the scope of the invention, it is intended that all matter contained in the above description be interpreted as illustrative and not in a limiting sense.

## Claims

1. A wafer sliced from a single crystal silicon ingot grown in accordance with the Czochralski method, the wafer comprising:
a front surface, a back surface, an imaginary central plane approximately equidistant between the front and back surfaces, a front surface layer which comprises a region of the wafer between the front surface and a distance, D₁, measured from the front surface and toward the central plane, and a bulk layer which comprises the imaginary central plane but not the front surface layer, and
a non-uniform concentration of crystal lattice vacancies, the concentration of the vacancies in the bulk layer being greater than the concentration of vacancies in the front surface layer,
wherein (i) D₁ is at least 5 microns and less than 30 microns, (ii) the surface layer has a resistivity of at least 100 ohm cm, and (iii) upon being subjected to an oxygen precipitation heat-treatment at a temperature in excess of about 700°C, the surface layer has less than about 1 x 10⁷ cm⁻³ oxygen precipitates while the bulk layer has more than about 1 x 10⁷ cm⁻³ oxygen precipitates.

2. The wafer of claim 1 wherein D₁ is greater than 5 microns and less than 25 microns.

3. The wafer of claim 1 wherein D₁ is greater than 5 microns and less than 20 microns.

4. The wafer of claim 1 wherein D₁ is greater than 5 microns and less than 15 microns.

5. The wafer of claim 1 wherein the surface layer has a resistivity of greater than 300 ohm cm.

6. The wafer of claim 1 wherein the surface layer has an interstitial oxygen concentration of less than about 10 PPMA.

7. The wafer of claim 1 wherein the wafer further comprises an epitaxial layer on the front surface.

8. The wafer of claim 1 wherein the bulk layer has more than about 1 x 10⁸ cm⁻³ oxygen precipitates.

9. A silicon on insulator structure comprising a device layer, a supporting layer and an insulating layer there between, the supporting layer comprising:
a first stratum and a second stratum, the first stratum (i) having a greater resistivity than the second stratum, (ii) extending from the insulating layer to the second stratum, and (iii) having a thickness, T₁, as measured from the insulating layer to the second stratum, and
a non-uniform concentration of crystal lattice vacancies, the concentration of the vacancies in the second stratum being greater than the concentration of vacancies in the first stratum,
wherein (i) T₁ is at least 5 microns and less than 30 microns, (ii) the first stratum has a resistivity of at least 100 ohm cm, and (iii) upon being subjected to an oxygen precipitation heat-treatment at a temperature in excess of about 700°C, the first stratum has an oxygen precipitate density of less than about 1 x 10⁷ cm⁻³ while the second stratum has an oxygen precipitate density of greater than about 1 x 10⁷ cm⁻³.

10. The silicon on insulator structure of claim 9 wherein T₁ is greater than 5 microns and less than 25 microns.

11. The silicon on insulator structure of claim 9 wherein the first stratum has a resistivity of greater than about 500 ohm cm.

12. The silicon on insulator structure of claim 9 wherein the first stratum has an interstitial oxygen concentration of less than about 10 PPMA.

13. The silicon on insulator structure of claim 9 wherein the insulating layer consists essentially of implanted ions.

14. The silicon on insulator structure of claim 13 wherein said implanted ions are oxygen or nitrogen.

15. A silicon on insulator structure comprising a silicon wafer, sliced from a single crystal silicon ingot grown in accordance with the Czochralski method, having
(i) a front surface, a back surface, an imaginary central plane approximately equidistant between the front and back surfaces,
(ii) a surface stratum which comprises a region of the wafer between the front surface and a distance, D, measured from the front surface and toward the central plane, and which includes a device layer and an insulating layer, the device layer extending from the front surface to the insulating layer,
(iii) a bulk stratum which comprises the imaginary central plane but not the surface stratum, and
(iv) a non-uniform concentration of crystal lattice vacancies, the concentration of the vacancies in the bulk stratum being greater than the concentration of vacancies in the surface stratum,
wherein (a) D is at least 5 microns and less than 30 microns, (b) the surface stratum has a resistivity of at least 100 ohm cm, and (c) upon being subjected to an oxygen precipitation heat-treatment at a temperature in excess of about 700°C, the surface stratum has an oxygen precipitate density of less than about 1 x 10⁷ cm⁻³ and the bulk stratum has an oxygen precipitate density of greater than about 1 x 10⁷ cm⁻³.

16. The silicon on insulator structure of claim 15 wherein the insulating layer comprises implanted ions.

17. The silicon on insulator structure of claim 16 wherein said implanted ions are oxygen or nitrogen.

18. The silicon on insulator structure of claim 15 wherein D is greater than 10 microns and less than 25 microns.

19. The silicon on insulator structure of claim 15 wherein the surface layer has an interstitial oxygen concentration of less than about 10 PPMA.

20. The silicon on insulator structure of claim 15 wherein the bulk layer has an oxygen precipitate density of greater than about 1 x 10⁸ cm⁻³.
